# EUROPÄISCHE PATENTSCHRIFT

(11) **EP 2 326 866 B1**
(45) Veröffentlichungstag und Bekanntmachung des Hinweises auf die Patenterteilung: **17.04.2013**
(21) Anmeldenummer: 09736801.3
(22) Anmeldetag: 01.09.2009
(51) Int. Cl.: H01L 51/52

(54) **ORGANISCHES, OPTOELEKTRONISCHES BAUTEIL**
ORGANIC, OPTOELECTRONIC COMPONENT
COMPOSANT OPTOÉLECTRONIQUE ORGANIQUE

(30) Priorität: 25.09.2008 DE 102008048829
(43) Veröffentlichungstag der Anmeldung: 01.06.2011
(73) Patentinhaber: OSRAM Opto Semiconductors GmbH, 93055 Regensburg (DE)
(72) Erfinder: SCHLENKER, Tilman, 93152 Nittendorf (DE); KLEIN, Markus, 93105 Tegernheim (DE)
(74) Vertreter: Epping - Hermann - Fischer
(86) Internationale Anmeldenummer: PCT/DE2009/001227
(87) Internationale Veröffentlichungsnummer: WO 2010/034280

(56) Entgegenhaltungen:
- EP-A1- 1 448 026
- EP-A2- 1 367 677
- DE-A1-102007 060 585
- JP-A- 10 039 811
- US-A1- 2005 110 384

## Beschreibung

Es wird ein organisches, optoelektronisches Bauteil angegeben.

Die Druckschrift EP-A-1 448 026 beschreibt ein organisches, optoelektronisches Bauteil.

Eine zu lösende Aufgabe besteht darin, ein organisches, optoelektronisches Bauteil anzugeben, das besonders einfach zu verkapseln ist. Eine weitere zu lösende Aufgabe besteht darin, ein organisches, optoelektronisches Bauteil anzugeben, das elektromagnetische Strahlung besonders gleichmäßig in verschiedene Richtungen abstrahlen kann.

Die Erfindung betrifft ein organisches, optoelektronisches Bauteil gemäß Anspruch 1.

Das Bauteil umfasst einen dreidimensionalen Substrat-Körper. Unter einem Substrat-Körper ist dabei ein Körper zu verstehen, der eine Substrat-Oberfläche aufweist. Eine Substrat-Oberfläche ist eine Oberfläche, auf die strahlungsemittierende Strukturen aufgebracht werden können. Die Substrat-Oberfläche ist dabei vorzugsweise glatt ausgebildet. Das heißt, die Substrat-Oberfläche weist eine nur geringe Rauigkeit auf. Auf diese Weise können Schichten gleichmäßiger Dicke besonders einfach auf die Substrat-Oberfläche aufgebracht werden.

Bei dem Substrat-Körper handelt es sich vorzugsweise um einen starren Körper, der keine oder kaum Flexibilität aufweist.

Der substrat-körper des Bauteils umfasst eine geschlossene Substrat-Oberfläche, die zur Aufnahme von strahlungsemittierenden Strukturen vorgesehen ist. Unter einer geschlossenen Oberfläche ist dabei eine Oberfläche des dreidimensionalen Substrat-Körpers zu verstehen, welche sich in alle drei Raumrichtungen erstreckt. Überfährt man die geschlossene Substrat-Oberfläche entlang einer vorgegebenen Richtung, so kann man nach einem Umlauf am Ausgangspunkt des Umlaufs enden. Bei der Substrat-Oberfläche handelt es sich also vorzugsweise um eine zusammenhängende, dreidimensionale Fläche.

Die Substrat-Oberfläche kann dabei zum Beispiel durch einen Teil einer Mantelfläche des dreidimensionalen Substrat-Körpers gebildet sein. Weist der Substrat-Körper in einer einfachen Ausführungsform beispielsweise die Form eines Zylinders auf, so kann die Substrat-Oberfläche durch einen umlaufenden Teil der Mantelfläche des Zylinders gebildet sein. Das heißt, der Zylinder ist dann zumindest stellenweise umlaufend mit einer geschlossenen Substrat-Oberfläche versehen. Handelt es sich bei dem Substrat-Körper in einer anderen, einfachen Ausführungsform um einen Hohlzylinder, so kann die Substrat-Oberfläche durch einen umlaufenden Bereich der Innenfläche des Zylinder-Mantels gebildet sein.

Insgesamt weist der Substrat-Körper also eine geschlossene, dreidimensionale Substrat-Oberfläche auf, die zur Aufnahme einer strahlungserzeugenden Struktur vorgesehen ist.

Das Bauteil umfasst ferner eine strahlungsemittierende Schichtenfolge, welche zumindest eine Schicht aufweist, die ein organisches Material enthält. Vorzugsweise handelt es sich bei dem organischen Material um ein Emitter-Material, das beispielsweise unter Bestromung mit einem elektrischen Strom elektromagnetische Strahlung emittiert. Vorzugsweise ist das organische Material dabei zur Emission von Licht, das heißt von sichtbarer, elektromagnetischer Strahlung geeignet. Bei dem Bauteil handelt es sich beispielsweise um eine organische, lichtemittierende Diode (OLED).

Die strahlungsemittierende Schichtenfolge ist auf die geschlossene Substrat-Oberfläche aufgebracht. Das heißt, die geschlossene Substrat-Oberfläche ist zumindest stellenweise von der strahlungsemittierenden Schichtenfolge bedeckt.

Dabei ist es möglich, dass die strahlungsemittierende Schichtenfolge derart auf der Substrat-Oberfläche aufgebracht ist, dass sie selbst eine gekrümmte Fläche bildet. Das heißt, zum Beispiel die der Substrat-Oberfläche abgewandte Oberseite der strahlungsemittierenden Schichtenfolge bildet eine dreidimensionale, gekrümmte Fläche. Das heißt, die strahlungsemittierende Schichtenfolge erstreckt sich entlang der drei Raumrichtungen. Die strahlungsemittierende Schichtenfolge bildet damit selbst eine dreidimensionale Struktur und stellt einen Teil eines dreidimensionalen Körpers dar. Die strahlungsemittierende Schichtenfolge folgt dabei in ihrem Verlauf zumindest stellenweise der Substrat-Oberfläche und weist eine dreidimensionale, gekrümmte Fläche auf.

Das Bauteil umfasst einen dreidimensionalen Substrat-Körper, der eine geschlossene Substrat-Oberfläche aufweist. Darüber hinaus umfasst das Bauteil eine strahlungsemittierende Schichtenfolge, die zumindest eine Schicht aufweist, die ein organisches Material enthält. Die strahlungsemittierende Schichtenfolge ist dabei auf die geschlossene Substrat-Oberfläche aufgebracht und bildet eine gekrümmte Fläche aus.

Einem hier beschriebenen organischen, optoelektronischen Bauteil liegt dabei unter anderem die Erkenntnis zugrunde, dass das organische Material der strahlungsemittierenden Schichtenfolge besonders einfach und mit nahezu 100 % Materialeffizienz auf eine geschlossene Substrat-Oberfläche aufgebracht werden kann. Ferner zeichnet sich eine dreidimensionale strahlungsemittierende Schichtenfolge, welche sich entlang der drei Raumrichtungen erstreckt, dadurch aus, dass sie elektromagnetische Strahlung in alle Raumrichtungen abgeben kann. Mit dem hier beschriebenen Bauteil ist daher ein Leuchtmittel herstellbar, das beispielsweise nach Art einer Glühbirne oder einer Leuchtstoffröhre einen Raum sehr gleichmäßig ausleuchten kann.

Der Substrat-Körper ist als Hohlkörper ausgebildet und die Substrat-Oberfläche ist durch zumindest einen Teil der Innenfläche des Hohlkörpers gebildet. Die Substrat-Oberfläche bildet dabei eine dreidimensionale Fläche. Die strahlungsemittierende. Schichtenfolge ist dann also zumindest stellenweise auf die Innenfläche des Hohlkörpers aufgebracht. Vorzugsweise bildet die strahlungsemittierende Schichtenfolge dabei eine geschlossene, umlaufende und gekrümmte Schicht. In jedem Fall beschreibt die strahlungsemittierende Schichtenfolge eine dreidimensionale Fläche, welche sich in sämtliche Raumrichtungen erstreckt.

Gemäß zumindest einer Ausführungsform ist der Substrat-Körper als Hohlkörper ausgebildet und weist zumindest eine Verjüngung auf. Im Bereich der Verjüngung nähern sich einander gegenüberliegende Punkte auf der Innenfläche des Hohlkörpers aneinander an. Die Punkte können sich dabei derart annähern, bis sie sich in einem Wulst berühren. Das heißt, der Hohlkörper kann im Bereich der Verjüngung durch ein Zusammenführen seiner Innenflächen nach außen hin geschlossen sein. Im Bereich der Verjüngung kann dann eine hermetische Versiegelung des Bauteils angeordnet sein. Entweder kann dazu zusätzliches Versiegelungsmaterial im Bereich der Verjüngung in den Hohlkörper eingebracht sein, oder die Innenflächen des Hohlkörpers sind derart zusammen geführt, dass sie einen Wulst bilden, der den Hohlkörper hermetisch dicht nach außen versiegelt.

Darüber hinaus ist es möglich, dass im Bereich der Verjüngung Anschlussleitungen zur elektrischen Kontaktierung der strahlungsemittierenden Schichtenfolge angeordnet sind, die von außerhalb des Substrat-Körpers in den Substrat-Körper hineinführen. Beispielsweise handelt es sich bei diesen Anschlussleitungen um Metalldrähte.

Beispielsweise ist es möglich, dass der Substrat-Körper als Hohlkörper ausgebildet ist und aus Glas besteht. Der Substrat-Körper kann dabei, in einer einfachen Ausführungsform, als Hohlzylinder ausgebildet sein. Im Bereich der Verjüngung reduziert sich der Durchmesser des Zylinders zu einem Wulst, in der sich einander gegenüberliegende Punkte auf der Innenfläche des Hohlkörpers berühren können. Das heißt, der Glaszylinder ist im Bereich der Verjüngung zu einem Wulst verschmolzen. Der Zylinder kann dabei an beiden stirnseitigen Enden eine solche Verjüngung aufweisen, wobei durch eine oder beide der Verjüngungen jeweils zumindest eine elektrische Anschlussleitung geführt sein kann, über welche die im Hohlkörper hermetisch versiegelte, strahlungsemittierende Schichtenfolge elektrisch kontaktierbar ist.

Insgesamt bildet der Substrat-Körper, der als Hohlkörper ausgebildet ist, zumindest einen Teil einer hermetischen Verkapselung. Das heißt, der Substrat-Körper weist eine Doppelfunktion auf: Zum einen stellt er die Substrat-Oberfläche zum Aufbringen der strahlungsemittierenden Schichtenfolge zur Verfügung. Zum anderen verkapselt er diese Schichtenfolge hermetisch vor äußeren Einflüssen wie Feuchtigkeit und atmosphärischen Gasen.

Das heißt, die strahlungsemittierende Schichtenfolge wird auf die Innenseite eines Hohlkörpers, zum Beispiel eines Glasrohrs, abgeschieden. Nach dem Abscheideprozess ist der Hohlkörper an seinen Innenflächen allseitig mit der strahlungsemittierenden Schichtenfolge bedeckt. Anschließend kann der Hohlkörper an seinen Enden verschmolzen oder mit hermetisch dichten Kappen abgedichtet werden. Auf diese Weise kann auf eine zusätzliche Verkapselungsschicht verzichtet werden. Es ist darüber hinaus nicht notwendig, Trockenmittel in den Hohlkörper einzubringen. Das Bauteil kann also frei von Trockenmittel oder Gettermaterial sein.

Hinsichtlich des Schutzes gegen Feuchtigkeit und atmosphärischer Gase erhält man auf diese Weise ein Bauteil, das prinzipiell unbeschränkte Haltbarkeit aufweist.

Als weiterer Vorteil kann angesehen werden, dass als Substrat-Körper ein preisgünstiges Glasrohr Verwendung finden kann, wie es beispielsweise für klassische Leuchtstofflampen bereits hergestellt wird. Ferner besteht die Möglichkeit, standardisierte Halterungen und elektrische Anschlüsse, wie sie für Leuchtstoffröhren bereits Verwendung finden, oder auch für Sparlampen gebräuchlich sind, zu verwenden. Dabei erweist sich als vorteilhaft, dass ein Hohlkörper mit nahe hundertprozentiger Materialeffizienz an seiner Innenseite beschichtet werden kann, da kaum Material entweichen kann, welches nicht zur Beschichtung Verwendung findet. Neben Glasröhren sind zur Bildung des Substrat-Körpers auch anders geformte Körper wie beispielsweise Kugeln, allgemeine Zylinder oder Spiralen denkbar.

Das im Folgenden beschriebene organische, optoelektronische Bauteil deint dem Verständnis der Erfindung. Die Substrat-Oberfläche des hier beschriedenen organichen optoelektronischen Bauteils ist durch zumindest einen Teil der Außenfläche des Substrat-Körpers gebildet. Das heißt, in diesem Bauteil ist das Material der strahlungsemittierenden Schichtenfolge nicht auf die Innenfläche eines Hohlkörpers aufgebracht, sondern auf die Außenfläche des dreidimensionalen Substrat-Körpers. Die strahlungsemittierende Schichtenfolge erstreckt sich auch in diesem Bauteil in sämtliche Raumrichtungen und bildet vorzugsweise eine geschlossene Fläche, die um den Substrat-Körper umläuft. Die strahlungsemittierende Schichtenfolge bildet eine dreidimensionale, gekrümmte Fläche aus.

Mit anderen Worten ist die strahlungsemittierende Schichtenfolge auf die Außenfläche beispielsweise eines spiralförmigen oder stabförmigen dreidimensionalen Körpers aufgebracht. Auch für dieses Bauteil ergibt sich der Vorteil, dass die strahlungsemittierende Schichtenfolge - aufgrund ihrer dreidimensionalen Erstreckung - elektromagnetische Strahlung in einem großen Raumbereich emittieren kann.

Das Bauteil umfasst neben dem Substrat-Körper einen Verkapselungs-Körper. Bei dem Verkapselungs-Körper handelt es sich um einen dreidimensionalen Körper, der als Hohlkörper ausgebildet ist. Der Hohlkörper ist dabei derart dimensioniert, dass er zur Aufnahme des Substrat-Körpers geeignet ist. Der Substrat-Körper ist dann zumindest mit denjenigen Bereichen des Substrat-Körpers, auf welche die strahlungsemittierende Schichtenfolge aufgebracht ist, innerhalb des Verkapselungs-Körpers angeordnet.

In einem einfachen Bauteil ist der Substrat-Körper durch einen zylindrischen Stab gebildet, der umlaufend mit der strahlungsemittierenden Schichtenfolge beschichtet ist. Der Verkapselungs-Körper ist dann durch einen Hohlzylinder gebildet, in welchen der Substrat-Körper hinein geschoben ist. Das heißt, in diesem Bauteil befindet sich die strahlungsemittierende Schichtenfolge nicht an der Innenfläche eines Hohlkörpers, sondern an der Außenfläche eines dreidimensionalen Substrat-Körpers, dem allseitig ein Verkapselungs-Körper in Abstrahlrichtung nachgeordnet sein kann.

Eine hermetische Versiegelung des Substrat-Körpers im Verkapselungs-Körper kann dann auf die gleiche Weise erfolgen, wie dies bereits für einen als Hohlkörper ausgebildeten Substrat-Körper beschrieben wurde. Das heißt, gemäß zumindest einer Ausführungsform kann der als Hohlkörper ausgebildete Verkapselungs-Körper eine Verjüngung aufweisen, wobei im Bereich der Verjüngung eine hermetische Versiegelung des Bauteils angeordnet ist. Beispielsweise kann der Verkapselungs-Körper an seinen stirnseitigen Enden jeweils zu einem Wulst verschmolzen sein. Dabei ist es wiederum möglich, dass Anschlussleitungen von außerhalb des Verkapselungs-Körper in den Verkapselungs-Körper hinein reichen. Über die Anschlussleitungen sind die auf dem Substrat-Körper angeordneten strahlungsemittierenden Schichten elektrisch kontaktierbar.

Der Substrat-Körper ist elektrisch leitend ausgebildet und die strahlungsemittierende Schichtenfolge ist elektrisch leitend mit dem Substrat-Körper verbunden. Vorzugsweise grenzt dann genau eine Elektrode, an welche die strahlungsemittierende Schichtenfolge elektrisch angeschlossen ist, an den elektrisch leitenden Substrat-Körper oder der Substrat-Körper bildet selbst die Elektrode, auf welche die strahlungsemittierende Schichtenfolge direkt aufgebracht ist. Eine derartige Ausführungsform ist insbesondere für ein hier beschriebenes Bauteil vorteilhaft, wenn die strahlungsemittierende Schichtenfolge auf die Außenfläche des dreidimensionalen Substrat-Körpers aufgebracht ist. Der Substrat-Körper kann in diesem Fall einen Grundkörper aufweisen, der mit einem elektrisch leitenden Material wie einem Metall beschichtet ist oder aus einem elektrisch leitenden Material, wie beispielsweise einem Metall bestehen. So ist es insbesondere möglich, dass der Substrat-Körper in diesem Fall durch einen zylindrischen oder spiralförmigen Metallstab gebildet ist.

Substrat-Körper und/oder Verkapselungs-Körper sind mit einem Glas gebildet. Das heißt, diese Körper können aus einem Glas bestehen oder enthalten ein Glas. Ein Glas erweist sich insbesondere zur Versiegelung eines Hohlkörpers als besonders vorteilhaft, da der Hohlkörper beispielsweise an seinen offenen Enden einfach in einem Wulst verschmolzen werden kann, durch welche dann eine hermetische Versiegelung gebildet ist. Darüber hinaus können glashaltige Körper besonders gut mittels einem Glaslotmaterial oder einem Glasfrittenmaterial hermetisch versiegelt werden.

Substrat-Körper und/oder Verkapselungs-Körper sind zumindest stellenweise nach Art eines der folgenden geometrischen Körper ausgebildet: Kugel, allgemeiner Zylinder, Spirale. Die Körper müssen dabei nicht der exakten geometrischen Form einer dieser Körper folgen, insbesondere im Bereich der Versiegelung können diese Körper von den beschriebenen geometrischen Grundformen abweichen. Substrat- und/oder Verkapselungs-Körper können jedoch auch als Mischformen der beschriebenen Körper ausgebildet sein, beispielsweise birnenförmig wie eine herkömmliche Glühbirne. Ist der Substrat-Körper und/oder der Verkapselungs-Körper in seiner Grundform wie eine Kugel ausgebildet, kann er beispielsweise die Form einer Christbaumkugel aufweisen und im Bereich seiner Versiegelung einen zylindrischen Vorsprung aufweisen.

Die Substrat-Oberfläche ist frei von Kanten. Den oben beschriebenen geometrischen Grundformen ist gemein, dass die Substrat-Oberfläche auf ihnen kantenfrei ausgebildet werden kann. Das heißt, die Substrat-Oberfläche weist keine Kanten auf, welche in einem spitzen Winkel zulaufen. Insbesondere ist in dieser Ausführungsform der Substrat-Körper nicht durch einen quaderförmigen Körper gebildet. Es hat sich nämlich gezeigt, dass es an den Kanten solcher Körper zu Fehlern in der strahlungsemittierenden Schichtenfolge oder den Elektroden des Bauteils kommen kann und ein gleichmäßiges Leuchten der gesamten strahlungsemittierenden Schichtenfolge damit erschwert ist.

Das erfindungsgemäße Bauteil umfasst zwei Substrat-Körper. Das Bauteil weist dabei einen ersten Substrat-Körper auf, der als Hohlkörper ausgebildet ist, wobei die Substrat-Oberfläche des ersten Substrat-Körpers durch zumindest einen Teil der Innenfläche des Hohlkörpers gebildet ist. Diese Substrat-Oberfläche ist mit einer ersten strahlungsemittierenden Schichtenfolge versehen.

Der zweite Substrat-Körper weist eine Substrat-Oberfläche auf, die durch zumindest einen Teil der Außenfläche des zweiten Substrat-Körpers gebildet ist. Auf diese Substrat-Oberfläche ist eine zweite strahlungsemittierende Schichtenfolge aufgebracht.

Der erste Substrat-Körper, der als Hohlkörper ausgebildet ist, bildet nun den Verkapselungs-Körper für den zweiten Substrat-Körper, wobei zumindest diejenigen Bereiche des zweiten Substrat-Körpers, auf welche die strahlungsemittierende schichtenfolge aufgebracht ist, innerhalb des ersten Substrat-Körpers angeordnet sind. Auf diese Weise ist es beispielsweise möglich, ein Bauteil anzugeben, das zumindest zwei strahlungsemittierende Schichtenfolgen aufweist.

Die erste strahlungsemittierende Schichtenfolge, auf dem ersten Substrat-Körper, ist dabei vorzugsweise transparent für die von der zweiten strahlungsemittierenden Schichtenfolge erzeugte elektromagnetische Strahlung.

Aus dem Bauteil entweicht Strahlung der von den beiden strahlungsemittierenden Schichtenfolgen emittierten elektromagnetischen Strahlung.

Ein derartiges Bauteil zeichnet sich neben seiner einfachen Herstellbarkeit auch durch seine besonders gute hermetische Verkapselung aus. Über die Kombination unterschiedlicher Substrat-Körper kann in der Produktion eine reichhaltige Palette unterschiedlicher Bauteile hergestellt werden, beispielsweise ist auf diese Weise die Produktion von kaltweißen und warmweißen Lichtquellen besonders einfach möglich.

Gemäß zumindest einer Ausführungsform sind Substrat-Körper und / oder Verkapselungskörper jeweils einstückig ausgebildet. Das heißt, diese Körper sind nicht aus mehreren Teilkörpern zusammengesetzt, sondern beispielsweise als einstückiges Rohr oder einstückiger Stab ausgebildet.

Im Folgenden wird das hier beschriebene Bauteil anhand von Ausführungsbeispielen und den dazugehörigen Figuren näher erläutert.

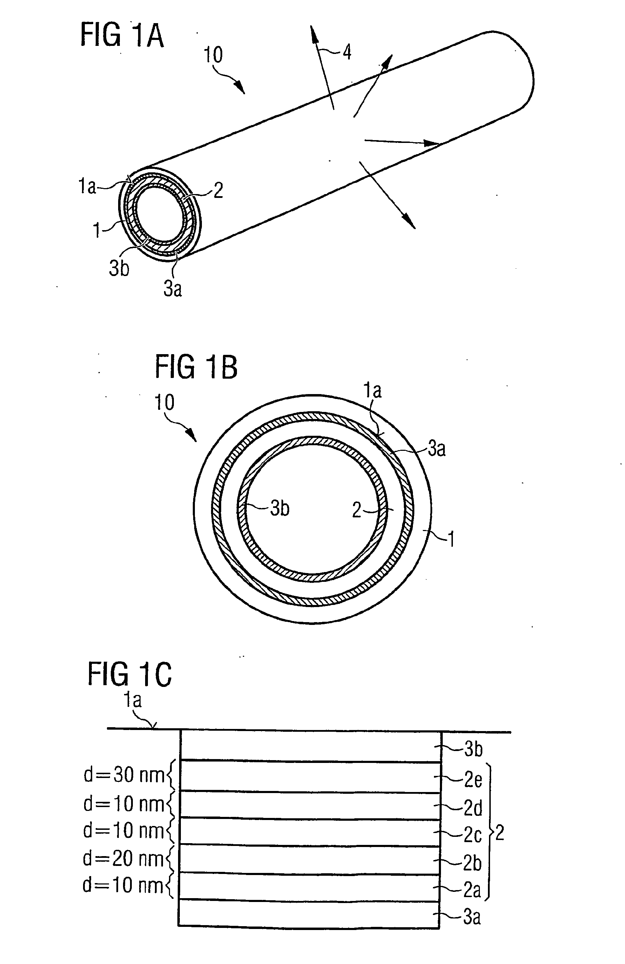

Die Figuren 1 bis 7 zeigen dabei schematische Darstellungen von hier beschriebenen Bauteilen sowie Prinzipskizzen für Herstellungsverfahren von hier beschriebenen Bauteilen.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

Die Figur 1A zeigt ein Bauteil 10 anhand einer schematischen Perspektivdarstellung. Das Bauteil 10 weist einen Substrat-Körper 1 auf, der aus einem Glas besteht. Der Substrat-Körper 1 ist vorliegend nach Art eines zylindrischen Stabes ausgeformt. Der Substrat-Körper 1 bildet einen Hohlkörper, an dessen Innenfläche die Substrat-Oberfläche 1a ausgebildet ist.

Auf der Substrat-Oberfläche 1a ist die erste Elektrode 3a des Bauteils aufgebracht. Die erste Elektrode 3a beschichtet die Innenfläche des Substrat-Körpers 1 dabei umlaufend.

Auf die erste Elektrode 3a ist die strahlungsemittierende Schichtenfolge 2 aufgebracht, die zumindest ein organisches Emittermaterial umfasst.

An der, der ersten Elektrode 3a abgewandten Außenfläche der strahlungsemittierenden Schichtenfolge 2 ist die zweite Elektrode 3b angeordnet. Die der zweiten Elektrode 3b zugewandte Außenfläche der Schichtenfolge 2 ist eine dreidimensional gekrümmte Fläche.

Im Betrieb des Bauteils 10 wird in der strahlungsemittierenden Schichtenfolge 2 elektromagnetische Strahlung 4 erzeugt, welche die Substrat-Körper 1 radial verlässt. Das heißt, das Bauteil weist eine radiale Abstrahlcharakteristik auf.

In Verbindung mit der Figur 1B ist anhand einer schematischen Schnittdarstellung die Schichtenfolge für das in Verbindung mit der Figur 1a beschriebene Bauteil nochmals dargestellt.

Die Figur 1C zeigt anhand einer schematischen Darstellung, eine mögliche Schichtabfolge zur Bildung der Elektroden 3a, 3b sowie der strahlungsemittierenden Schichtenfolge 2. Die erste Elektrode 3a ist dabei vorzugsweise aus einem strahlungsdurchlässigen Material wie ITO (Indium Tin Oxide) gebildet.

Die strahlungsemittierende Schichtenfolge 2 umfasst zum Beispiel den folgenden Schichtaufbau, der zur Erzeugung von weißem Licht geeignet ist:
- eine Schicht 2a, die der ersten Elektrode 3a direkt nachfolgt und 1-TNATA umfasst,
- eine Schicht 2b, die der Schicht 2a direkt nachfolgt und s-TAD umfasst,
- eine Schicht 2c, die der Schicht 2b direkt nachfolgt und SEB-010:SEB020 umfasst,
- eine Schicht 2d, die der Schicht 2c direkt nachfolgt und TMM-004:Ir(ppy)3 (15 %) umfasst, und
- eine Schicht 2e, die der Schicht 2d direkt nachfolgt und TMM-04:TER012 umfasst.

Beispielsweise weisen die Schichten der strahlungsemittierenden Schichtenfolge 2 folgende Dicken auf:
- die Schicht 2a hat eine Dicke d von zirka 40 nm,
- die Schicht 2b hat eine Dicke d von zirka 20 nm,
- die Schicht 2c hat eine Dicke d von zirka 10 nm,
- die Schicht 2d hat eine Dicke d von zirka 10 nm, und
- die Schicht 2e hat eine Dicke d von zirka 30 nm.

Die Emission von in der strahlungsemittierenden Schichtenfolge 2 erzeugter elektromagnetischer Strahlung erfolgt dabei durch die erste Elektrode 3a hindurch, die strahlungsdurchlässig oder transparent ausgebildet ist.

Die zweite Elektrode 3b bildet eine Kathode und ist beispielsweise aus einem reflektiven Metall wie Silber oder Aluminium gebildet. Elektromagnetische Strahlung 4, welche in der strahlungsemittierenden Schichtenfolge 2 erzeugt wird, wird also an der zweiten Elektrode 3b in Richtung des Substrat-Körpers 1 reflektiert und kann durch die durchlässige erste Elektrode 3a zunächst in den Substrat-Körper 1 und von dort nach außen gelangen.

Im beziehungsweise.auf dem Substrat-Körper 1 kann auch eine transparente Schichtenfolge 2 mit transparenten Elektroden 3a, 3b abgeschieden werden. So kann zum Beispiel ein transparentes Rohr mit einer transparenten OLED an der Innenseite verwendet werden. Hierdurch kann eine bessere Farbmischung über den Betrachtungswinkel erzeugt werden.

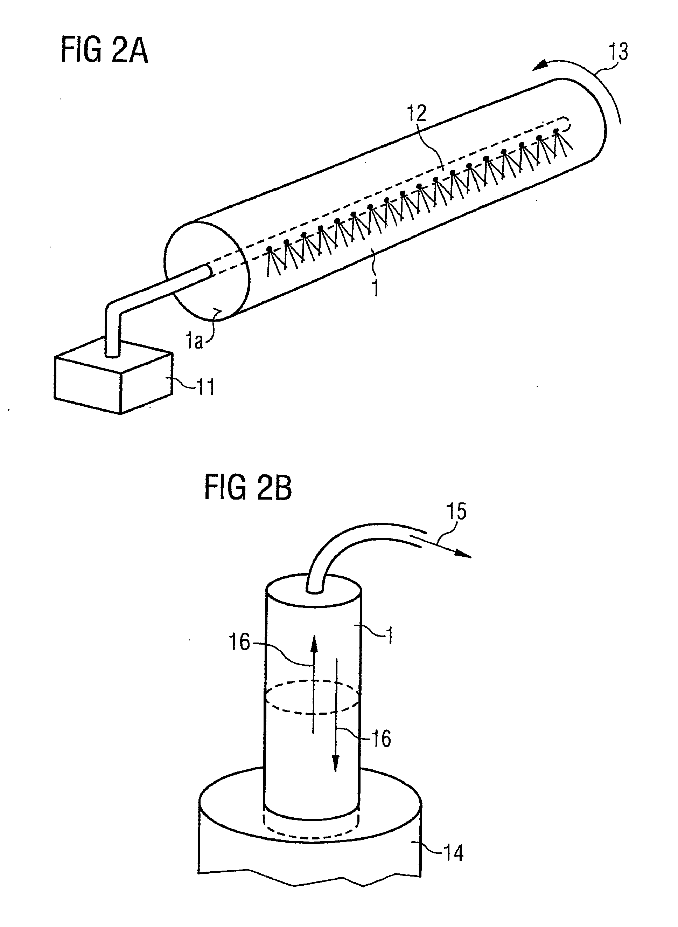

In Verbindung mit den Figuren 2A und 2B sind anhand zweiter schematischer Perspektivdarstellungen zwei verschiedene Möglichkeiten zur Herstellung eines in Verbindung mit den Figuren 1A bis 1C beschriebenen Bauteils näher erläutert.

In Verbindung mit der Figur 2A ist ein Herstellungsverfahren beschrieben, bei dem über ein Verteilerrohr 12 beispielsweise das Material der Elektroden 3a, 3b sowie die strahlungsemittierenden Schichtenfolge 2 aus dem Verdampfer 11 auf die Innenfläche des Substrat-Körpers 1 aufgebracht wird. Der Substrat-Körper wird beim Beschichten in Drehrichtung 13 gedreht. Auf diese Weise erfolgt eine gleichmäßige Beschichtung der Substrat-Oberfläche 1a des Substrat-Körpers 1 mittels eines Linearbeschichters.

Neben Vakuumabscheidungsverfahren für die strahlungsemittierende Schichtenfolge 2 und Verfahren zur Herstellung der Elektroden 3a, 3b wie MBE (molecular beam epitaxy), VTE (vacuum thermal evaporation), Sputtern, PECVD (plasmaunterstützte chemische Gasphasenabscheidung) sind auch Flüssigphasenprozesse wie Sol-Gel-Verfahren, dip-coating, Sprühen, doctor-blading, wet processing coating oder hybride Herstellungsverfahren denkbar.

So wird beim in Verbindung mit der Figur 2B beschriebenen Herstellungsverfahren mittels einer Pumpe beispielsweise flüssiges Material zur Bildung der strahlungsemittierenden Schichtenfolge 2 aus einem Reservoire 14 in Richtung Pumprichtung 15 transportiert. Das Material fließt in der Richtung 16 entlang der Substrat-Oberfläche 1a des Substrat-Körpers 1 und beschichtet auf diese Weise den Substrat-Körper 1.

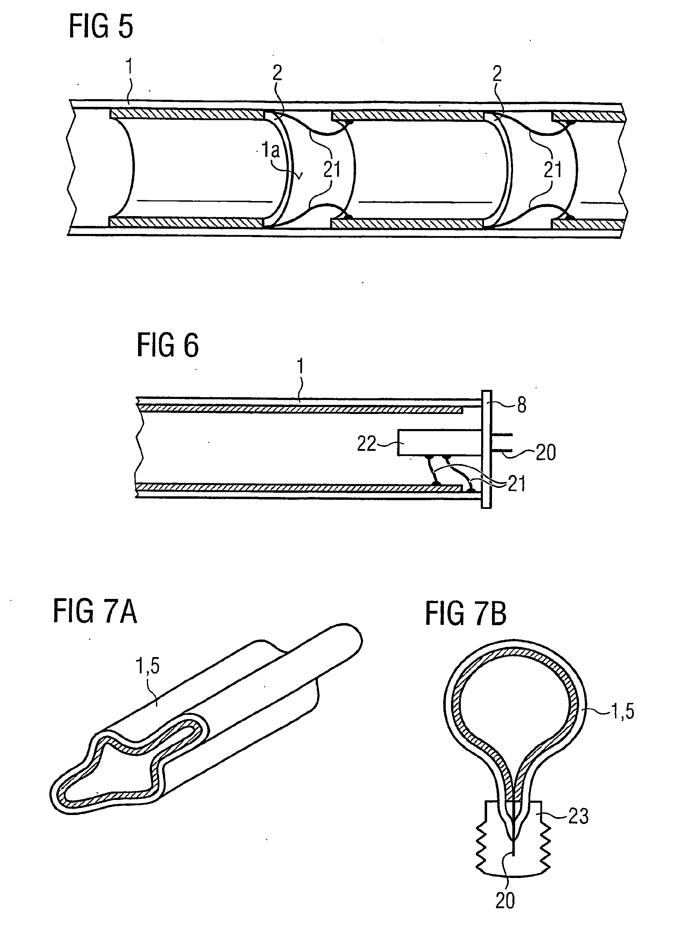

Auch für gebogene, zum Beispiel spiralförmige, Glasrohre als Substrat-Körper 1 bieten sich die Verwendung als Kompaktlampen an. Auch in oder auf solche spiralförmigen Substrat-Körper 1 kann eine spiralförmige Aufdampfquelle einführt werden. Diese Substrat-Körper 1 können nach dem Beschichten aufgeschmolzen und mit einer Steuervorrichtung 22 (siehe auch Figur 6) in einen Sockel gesetzt werden. Damit entspricht das Bauteil vom äußeren Erscheinungsbild einer heute typischen Kompaktsparlampe.

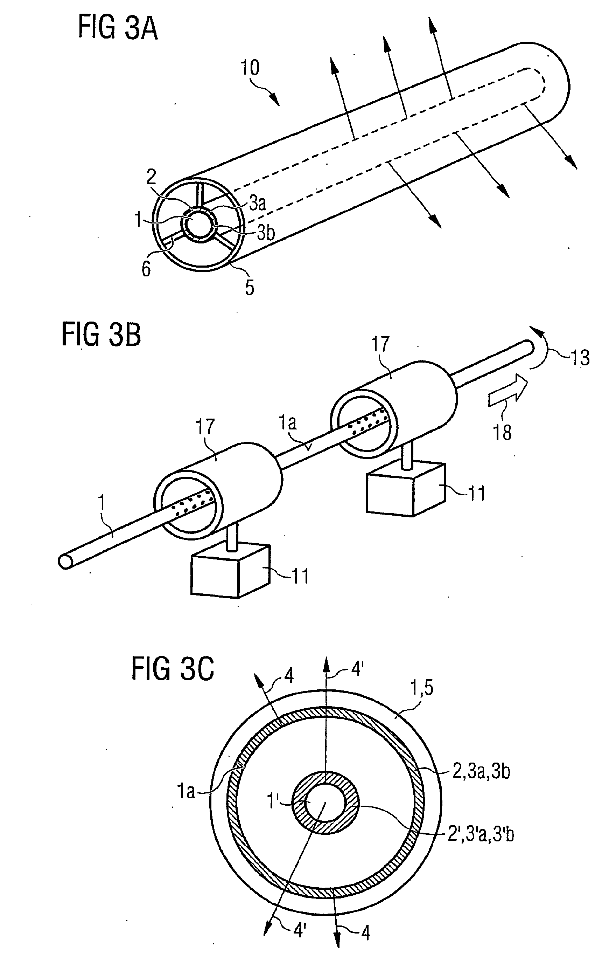

In Verbindung mit der Figur 3A ist ein weiteres Bauteil näher erläutert. In diesem Bauteil sind die Schichten erste und zweite Elektrode 3a, 3b sowie die strahlungsemittierende Schichtenfolge 2 auf die Außenfläche des Substrat-Körpers 1 aufgebracht. Der Substrat-Körper 1 kann dabei aus Glas bestehen oder aus einem Metall gebildet sein. Der Substrat-Körper 1 ist mittels Abstandshalter 6 im Verkapselungs-Körper 5, der als Hohlkörper ausgebildet ist, eingebracht. Die Schichtenfolge ist dabei wie in Verbindung mit der Figur 1c beschrieben.

In Verbindung mit der Figur 3B ist anhand einer schematischen Perspektivdarstellung ein mögliches Verfahren zur Beschichtung der Außenfläche des Substrat-Körpers 1 gezeigt. Die Beschichtung erfolgt dabei mittels Hohlraumbeschichter 17, denen das zu beschichtende Material durch die Verdampfer 11 zugeführt wird. Der Substrat-Körper 1 kann dabei in Richtung der Translationsrichtung 18 verschoben werden, wodurch es ermöglicht ist, dass jeder Hohlraumbeschichter 17 eine andere Schicht des Bauteils auf die Außenfläche des Substrat-Körpers 1 aufbringt. Während des Beschichtens kann zudem eine Drehung in Drehrichtung 13 des Substrat-Körpers 1 erfolgen, was zusätzlich zu einer besonders homogenen Beschichtung des Substrat-Körpers 1 führt.

In Verbindung mit der Figur 3C ist anhand einer schematischen Schnittdarstellung das erfindungsgemäße Bauteil näher erläutert. In diesem Ausführungsbeispiel umfasst das Bauteil zwei Substrat-Körper 1. Der erste Substrat-Körper 1 ist dabei gleichzeitig ein Verkapselungs-Körper 5 für den zweiten Substrat-Körper 1', der durch einen Stab gebildet sein kann. Das Bauteil umfasst auf diese Weise zwei strahlungsemittierende Schichtenfolgen 2, 2', die unterschiedliche Emittermaterialien aufweisen können und damit elektromagnetische Strahlung unterschiedlicher Wellenlängen emittieren. Vom Bauteil wird auf diese Weise Mischstrahlung 4, 4' aus beiden strahlungsemittierenden Schichtenfolgen emittiert. Die zweite Elektrode 3b, die auf die Innenfläche des als Hohlkörper ausgebildeten Substrat-Körpers 1 aufgebracht ist, ist dabei transparent für die in der zweiten strahlungsemittierenden Schichtenfolge 2' erzeugte elektromagnetische Strahlung ausgebildet.

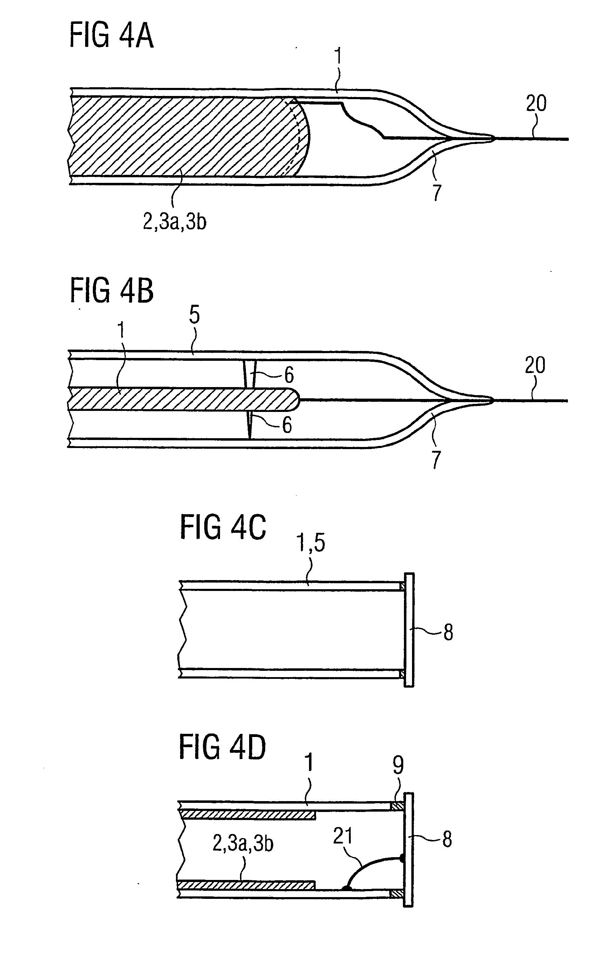

In Verbindung mit den Figuren 4A, 4B, 4C und 4D sind anhand schematischer Schnittdarstellungen unterschiedliche Möglichkeiten zur hermetischen Versiegelung von Bauteilen erläutert.

In den Figuren 4A und 4B erfolgt die Versiegelung durch eine Verjüngung 7 am stirnseitigen Ende des Substrat-Körpers 1 beziehungsweise des Verkapselungs-Körpers 5. Durch die Verjüngung 7 ist eine elektrische Anschlussleitung 20 geführt, mittels der die strahlungsemittierende Schichtenfolge 2 kontaktiert werden kann. Wie aus den Figuren 4A und 4B ersichtlich, kann die gleiche Versiegelungsmethode dabei sowohl für ein Bauteil Verwendung finden, bei dem der Substrat-Körper 1 als Hohlkörper ausgebildet ist, als auch für ein Bauteil, bei dem die Außenfläche des Substrat-Körpers 1 mit dem strahlungsemittierenden Material beschichtet ist.

In Verbindung mit den Figuren 4C und 4D sind alternative Möglichkeiten zur Versiegelung beschrieben. Beim in Verbindung mit der Figur 4C beschriebenen Beispiel wird eine Kappe 8 aus Glas oder Keramikmaterial mittels einem Glaslot oder einer Glasfritte mit dem Substrat-Körper 1 beziehungsweise dem Verkapselungs-Körper 5 hermetisch verbunden. Das Aufschmelzen des Glaslotes beziehungsweise des Glasfrittenmaterials zum Verbinden von Kappe 8 und Substrat-Körper 1 beziehungsweise Verkapselungs-Körper 5 kann dabei lokal mittels eines Laserstrahls erfolgen.

In der Figur 4D ist ein Ausführungsbeispiel beschrieben, bei dem eine Keramik- oder Metall-Kappe mittels einem elektrisch leitenden Verbindungsmaterial 9 mit dem Substrat-Körper 1 beziehungsweise dem Verkapselungs-Körper 5 verbunden ist. Es kann sich dann im Falle einer Keramik-Kappe 8 um eine kapazitive Koppelung und im Falle einer Metall-Kappe 8 um eine elektrisch leitende Verbindung handeln. Über die Metall-Kappe 8 kann also auch ein Kontaktieren der strahlungsemittierenden Schichtenfolge 2 über eine elektrische Verbindung 21 erfolgen.

Anhand der schematischen Perspektivdarstellung der Figur 5 ist ein Bauteil näher erläutert, bei dem beispielsweise auf die Innenfläche eines als Hohlkörper ausgebildeten Substrat-Körpers 1 mehrere strahlungsemittierende Schichtenfolgen 2 getrennt voneinander aufgebracht sind. Diese sind mittels elektrischen Verbindungen 21 in Serie miteinander verschaltet. Die getrennt voneinander aufgebrachten strahlungsemittierenden Schichtenfolgen 2 können dabei voneinander unterschiedliche Emittermaterialien enthalten, so dass sie auch geeignet sein können, Strahlung von voneinander unterschiedlicher Wellenlänge zu erzeugen. Das heißt, das Bauteil 10 der Figur 5 wird auf dem länglichen Substrat-Körper 1 in zum Beispiel Zylinderscheiben segmentiert. Die einzelnen Segmente werden dabei bevorzugt serienverschaltet, wodurch die Gesamtspannung zwar steigt, der Strom aber verringert wird. Dies hat Vorteile im Hinblick auf Uniformität der Stromverteilung, da die Anforderungen der Stromtragfähigkeit heruntergesetzt werden. Dies ist speziell für transparente Elektroden 3a, 3b besonders vorteilhaft.

In Verbindung mit der Figur 6 ist anhand einer schematischen Schnittdarstellung ein Bauteil näher erläutert, bei dem eine Steuervorrichtung 22 innerhalb eines Substrat-Körpers 1 angeordnet ist. Über die Steuervorrichtung 22 kann beispielsweise eine geeignete Bestromung der strahlungsemittierenden Schichtenfolge 2 mit geeigneten Stromstärken bei geeigneten Spannungen erfolgten. Diese Anordnung ist dabei auch für Bauteile möglich, die einen Verkapselungs-Körper 5 umfassen.

Die Ansteuerelektronik der Steuervorrichtung 22 kann entweder im Substrat-Körper 1 oder in direkter Verlängerung auf eines oder beide Enden des Substrat-Körpers 1 aufgebracht werden, so dass zum Beispiel ein Betrieb an einer Spannungsquelle möglich ist. Dies hat den Vorteil, dass unterschiedliche Bauteile 10 an der gleichen Versorgungsspannung betrieben werden können und sich den jeweils benötigten Strom mittels der integrierten Steuervorrichtung 22 selbst bereitstellen.

Die.im Bauteil 10 integrierte Steuervorrichtung 22 kann derart gestaltet sein, dass die "OLED Leuchtstofflampe" mit heute eingesetzter Elektronikinstallation direkt betrieben werden kann.

An den stirnseitigen Enden des Bauteils 10 können Maßnahmen vorhanden sein, mit denen man dem Bauteil 10 auch ohne elektrisch leitfähigem Kontakt Energie zuführen kann. Diese kann zum Beispiel induktiv oder kapazitiv eingekoppelt werden.

In Verbindung mit den Figuren 7A und 7B sind anhand schematischer Darstellungen mögliche Formen für die Substrat-Körper 1 beziehungsweise Verkapselungs-Körper 5 von hier beschriebenen Bauteilen näher erläutert. In Verbindung mit der Figur 7A ist ein Substrat-Körper 1 beziehungsweise ein Verkapselungs-Körper 5 näher erläutert, der als allgemeiner Zylinder ausgebildet ist. Die Form des Körpers 1, 5 kann dabei an die Einsatzerfordernisse beziehungsweise Designanforderungen des Bauteils angepasst werden.

In Verbindung mit der Figur 7B ist schematisch erläutert, dass ein hier beschriebenes organisches Bauteil in Form einer Glühbirne ausgebildet werden kann, welche mittels eines Sockels 23, der beispielsweise als Edison-Sockel ausgebildet ist, elektrisch kontaktiert werden kann.

Die Erfindung ist nicht durch die Beschreibung anhand der Ausführungsbeispiele auf diese beschränkt. Vielmehr umfasst die Erfindung jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Organisches, optoelektronisches Bauteil (10) mit
- einem dreidimensionalen ersten Substrat-Körper (1), der als Hohlkörper ausgebildet ist und der eine geschlossene Substrat-Oberfläche (1a) aufweist, wobei die Substrat-Oberfläche (1a) des ersten Substrat-Körpers durch zumindest einen Teil der Innenfläche des Hohlkörpers gebildet ist,
- einem dreidimensionalen zweiten Substrat-Körper (1'), der eine geschlossene Substrat-Oberfläche (1a') aufweist, wobei die Substrat-Oberfläche (1a') des zweiten Substrat-Körpers (1') durch zumindest einen Teil der Außenfläche des zweiten Substrat-Körpers (1') gebildet ist,
- einer ersten strahlungsemittierenden Schichtenfolge (2), die zumindest eine Schicht (2a, 2b, 2c, 2d, 2e) aufweist, die ein organisches Material enthält, und
- einer zweiten strahlungsemittierenden Schichtenfolge (2'), die zumindest eine Schicht aufweist, die ein organisches Material enthält, wobei
- die erste strahlungsemittierende Schichtenfolge (2) auf die geschlossene Substrat-Oberfläche (1a) des ersten Substrat-Körpers (1)aufgebracht ist und eine gekrümmte Fläche bildet,
- die zweite strahlungsemittierende Schichtenfolge (2') auf die geschlossene Substrat-Oberfläche (1a') des zweiten Substrat-Körpers (1')aufgebracht ist und eine gekrümmte Fläche bildet,
- der erste Substrat-Körper (1) einen Verkapselungs-Körper (5) für den zweiten Substrat-Körper (1') bildet, und zumindest diejenigen Bereiche des zweiten Substrat-Körpers (1'), auf welche die zweite strahlungsemittierende Schichtenfolge (2') aufgebracht ist, innerhalb des ersten Substrat-Körpers (1) angeordnet sind.

2. Organisches, optoelektronisches Bauteil nach dem vorherigen Anspruch,
bei dem der Hohlkörper zumindest eine Verjüngung (7) aufweist.

3. Organisches, optoelektronisches Bauteil nach dem vorherigen Anspruch,
bei dem im Bereich der Verjüngung (7) Anschlussleitungen(20) zur elektrischen Kontaktierung der ersten strahlungsemittierenden Schichtenfolge (2) angeordnet sind, die von außerhalb des Substrat-Körpers (1) in den Substrat-Körper (1) hinein führen.

4. Organisches, optoelektronisches Bauteil nach Anspruch 2 oder 3,
bei dem im Bereich der Verjüngung (7) eine hermetische Versiegelung des Bauteils (10) angeordnet ist.

5. Organisches, optoelektronisches Bauteil nach einem der vorherigen Ansprüche,
bei dem der Hohlkörper zumindest einen Teil einer hermetischen Verkapselung für die erste strahlungsemittierende Schichtenfolge (2) bildet.

6. Organisches, optoelektronisches Bauteil nach Anspruch 1, bei dem der zweite Substrat-Körper (1') elektrisch leitend ist und die zweite strahlungsemittierende Schichtenfolge (2') elektrisch leitend mit dem zweiten Substrat-Körper (1') verbunden ist.

7. Organisches, optoelektronisches Bauteil nach einem der vorherigen Ansprüche,
bei dem der zweite Substrat-Körper (1') und/oder der erste Substrat-Körper (1) ein Glas enthalten oder aus einem Glas bestehen.

8. Organisches, optoelektronisches Bauteil nach einem der vorherigen Ansprüche,
bei dem der zweite Substrat-Körper (1') und/oder der erste Substrat-Körper (1) zumindest stellenweise nach Art eines der folgenden geometrischen Körper ausgebildet sind: Kugel, allgemeiner Zylinder, Spirale.

9. Organisches, optoelektronisches Bauteil nach einem der vorherigen Ansprüche,
bei dem die geschlossene erste und die zweite Substrat-Oberfläche (1a, 1a') frei von Kanten sind.

10. Organisches, optoelektronisches Bauteil nach einem der vorherigen Ansprüche,
bei dem die erste strahlungsemittierende Schichtenfolge (2) transparent für die von der zweiten strahlungsemittierenden Schichtenfolge (2') erzeugte elektromagnetische Strahlung ist.

## Claims

1. Organic, optoelectronic component (10) comprising
- a three-dimensional first substrate body (1), which is embodied as a hollow body and has a closed substrate surface (1a), wherein the substrate surface (1a) of the first substrate body is formed by at least one portion of the inner area of the hollow body,
- a three-dimensional second substrate body (1'), which has a closed substrate surface (1a'), wherein the substrate surface (1a') of the second substrate body (1') is formed by at least one portion of the outer area of the substrate body (1'),
- a first radiation-emitting layer sequence (2), which has at least one layer (2a, 2b, 2c, 2d, 2e), containing an organic material, and
- a second radiation-emitting layer sequence (2'), which has at least one layer containing an organic material, wherein
- the first radiation-emitting layer sequence (2) is applied to the closed substrate surface (1a) of the first substrate body (1) and forms a curved area,
- the second radiation-emitting layer sequence (2') is applied to the closed substrate surface (1a') of the second substrate body (1') and forms a curved area,
- the first substrate body (1) forms an encapsulation body (5) for the second substrate body (1'), and at least those regions of the second substrate body (1') to which the second radiation-emitting layer sequence (2') is applied are arranged within the first substrate body (1).

2. Organic, optoelectronic component according to the preceding claim,
wherein the hollow body has at least one tapered section (7).

3. Organic, optoelectronic component according to the preceding claim,
wherein connecting lines (20) for making electrical contact with the first radiation-emitting layer sequence (2) are arranged in the region of the tapered section (7), said connecting lines leading into the substrate body (1) from outside the substrate body (1).

4. Organic, optoelectronic component according to Claim 2 or 3,
wherein a hermetic sealing of the component (10) is arranged in the region of the tapered section (7).

5. Organic, optoelectronic component according to any of the preceding claims,
wherein the hollow body forms at least one portion of a hermetic encapsulation for the first radiation-emitting layer sequence (2).

6. Organic, optoelectronic component according to Claim 1,
wherein the second substrate body (1') is electrically conductive and the second radiation-emitting layer sequence (2') is electrically conductively connected to the second substrate body (1').

7. Organic, optoelectronic component according to any of the preceding claims,
wherein the second substrate body (1') and/or the first substrate body (1) contain(s) a glass or consist(s) of a glass.

8. Organic, optoelectronic component according to any of the preceding claims,
wherein the second substrate body (1') and/or the first substrate body (1) are/is embodied at least in places in the manner of one of the following geometrical bodies: sphere, general cylinder, spiral.

9. Organic, optoelectronic component according to any of the preceding claims,
wherein the closed first and the second substrate surface (1a, 1a') are free of edges.

10. Organic, optoelectronic component according to any of the preceding claims,
wherein the first radiation-emitting layer sequence (2) is transparent to the electromagnetic radiation generated by the second radiation-emitting layer sequence (2').

## Revendications

1. Composant optoélectronique organique (10) présentant :
un premier corps tridimensionnel de substrat (1), configuré en corps creux et présentant une surface fermée (1a) de substrat, la surface (1a) de substrat du premier corps de substrat étant formée par au moins une partie de la surface intérieure du corps creux,
un deuxième corps tridimensionnel de substrat (1') présentant une surface fermée (1a') de substrat, la surface (1a') de substrat du deuxième corps de substrat (1') étant formée par au moins une partie de la surface extérieure du deuxième corps de substrat (1'),
une première succession (2) de couches d'émission d'un rayonnement qui présente au moins une couche (2a, 2b, 2c, 2d, 2e) qui contient un matériau organique et
une deuxième succession (2') de couches d'émission d'un rayonnement qui présente au moins une couche qui contient un matériau organique,
la première succession (2) de couches d'émission d'un rayonnement étant appliquée sur la surface fermée (1a) du premier corps de substrat (1) et formant une surface courbe,
la deuxième succession (2') de couches d'émission d'un rayonnement étant appliquée sur la surface fermée (1a') du deuxième corps de substrat (1') et formant une surface courbe,
le premier corps de substrat (1) formant un corps d'encapsulation (5) du deuxième corps de substrat (1') et au moins les parties du deuxième corps de substrat (1') sur lesquelles la deuxième succession (2') de couches d'émission d'un rayonnement est appliquée étant situées à l'intérieur du premier corps de substrat (1).

2. Composant optoélectronique organique selon la revendication précédente, dans lequel le corps creux présente au moins un rétrécissement (7).

3. Composant optoélectronique organique selon la revendication précédente, dans lequel des conducteurs de raccordement (20) qui établissent le contact électrique avec la première succession (2) de couches d'émission d'un rayonnement et qui pénètrent à l'intérieur du corps de substrat (1) depuis l'extérieur du corps de substrat (1) sont prévus au niveau du rétrécissement (7).

4. Composant optoélectronique organique selon les revendications 2 ou 3, dans lequel un scellage hermétique du composant (10) est prévu au niveau du rétrécissement (7).

5. Composant optoélectronique organique selon l'une des revendications précédentes, dans lequel le corps creux forme au moins une partie de l'encapsulation hermétique de la première succession (2) de couches d'émission d'un rayonnement.

6. Composant optoélectronique organique selon l'une des revendications précédentes, dans lequel le deuxième corps de substrat (1') est électriquement conducteur et en ce que la deuxième succession (2') de couches d'émission d'un rayonnement est raccordée de manière électriquement conductrice au deuxième corps de substrat (1').

7. Composant optoélectronique organique selon l'une des revendications précédentes, dans lequel le deuxième corps de substrat (1') et/ ou le premier corps de substrat (1) contiennent du verre ou sont formés de verre.

8. Composant optoélectronique organique selon l'une des revendications précédentes, dans lequel au moins certains emplacements du deuxième corps de substrat (1') et/ ou du premier corps de substrat (1) sont configurées en au moins l'un des corps géométriques suivants : sphère, cylindre général et spirales.

9. Composant optoélectronique organique selon l'une des revendications précédentes, dans lequel la première surface fermée et la deuxième surface (1a, 1a') du substrat sont dépourvues d'arête.

10. Composant optoélectronique organique selon l'une des revendications précédentes, dans lequel la première succession (2) de couches d'émission d'un rayonnement est transparente au rayonnement produit par la deuxième succession (2') de couches d'émission d'un rayonnement.
